**Europäisches Patentamt**

(19) **European Patent Office**

**Office européen des brevets**

(11) Publication number : **0 289 625 B1**

(12) **EUROPEAN PATENT SPECIFICATION**

(45) Date of publication of patent specification :
22.07.92 Bulletin 92/30

(51) Int. Cl.⁵ : **H04Q 9/00**

(21) Application number : **87907521.6**

(22) Date of filing : **11.11.87**

(86) International application number :
**PCT/JP87/00873**

(87) International publication number :
**WO 88/03736 19.05.88 Gazette 88/11**

(54) **REMOTE COMMANDER.**

(30) Priority : **12.11.86 JP 269400/86**

(43) Date of publication of application :
**09.11.88 Bulletin 88/45**

(45) Publication of the grant of the patent :
**22.07.92 Bulletin 92/30**

(84) Designated Contracting States :
**DE FR GB**

(56) References cited :
**JP-A-60 254 898**
**JP-A-61 111 089**
**JP-A-61 201 571**

(73) Proprietor : **SONY CORPORATION**
**7-35 Kitashinagawa 6-chome Shinagawa-ku**
**Tokyo 141 (JP)**

(72) Inventor : **KURITA, Tohru Sony Corporation**
**7-35, Kitashinagawa 6-chome**
**Shinagawa-ku Tokyo 141 (JP)**

(74) Representative : **Cotter, Ivan John et al**
**D. YOUNG & CO. 10 Staple Inn**
**London WC1V 7RD (GB)**

## Description

This invention relates to remote commanders for remotelycontrolled equipment.

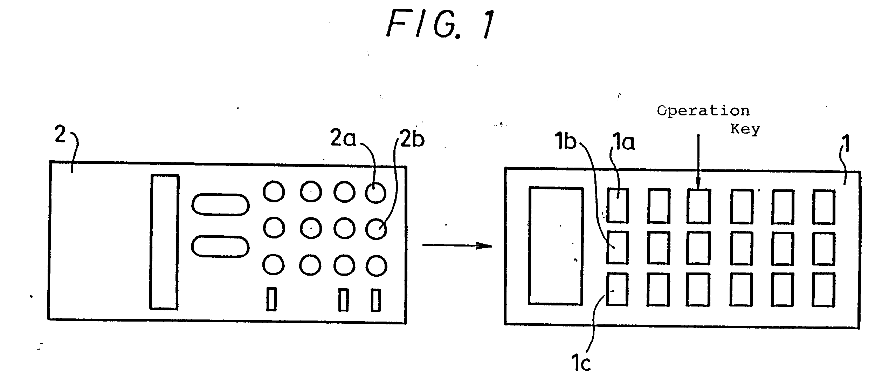

When a so-called AV system is arranged by combining a television (TV) receiver made by a company S, a video tape recorder (VTR) made by another company V, and audio equipment made by, for example, a company M, the respective pieces of equipment are in general independently operated by remote commanders for remotely-controlled apparatuses that belong to the respective pieces of equipment, which arrangement is inconvenient to use. To remove this disadvantage, Japanese Patent Application Publication No JP-A-60 254 878 proposes such a remote commander that can store data transmitted from another remote commander and can transmit the thus-stored transmitted data again. In Figure 1 of the accompanying drawings, reference numeral 1 designates a previously-proposed remote commander capable of re-transmitting the thus transmitted data, and reference numeral 2 designates a remote commander for a remotely-controlled apparatus that belongs to the TV receiver made by, for example, the company S, a remote commander for a remotely-controlled apparatus that belongs to the video tape recorder made by the company V, or a remote commander for a remotely-controlled apparatus that belongs to the audio equipment made by the company M. In the remote commander 2, command operations are determined in well known manner by a plurality of operation keys 2a, 2b ... . Also, predetermined transmitting data are transmitted by operating the respective operation keys 2a, 2b ... . The remote commander 1 is arranged to switch between a memory mode and a transmission mode. In the memory mode of the remote commander 1, as shown in Figure 1, a transmitting section of the other remote commander 2 is located in correspondence with a receiving section of the remote commander 1, whereby when the operation key 2a of the operations keys 2a, 2b ... corresponds with, for example, the key 1a of the desired keys 1a, 1b ... and they are operated together, data transmitted by operating, for example, the operation key 2a of the other remote commander 2 is stored in the remote commander 1 at a memory section thereof corresponding, for example, to the operation key 1a. In the transmission mode of the remote commander 1, when the operation keys 1a, 1b ... are operated, the transmitted data stored in correspondence therewith are transmitted. Accordingly, in such a remote commander 1, when data transmitted in correspondence with the respective operating keys of the remote commander that belongs to the TV receiver made by the company S, data transmitted in correspondence with the respective operating keys of the remote commander that belongs to the VTR made by the company V, and data transmitted in correspondence with the respective operating keys of the remote commander that belongs to the audio equipment made by the company M, are stored in response to the respective operation keys 1a, 1b ..., the above-mentioned AV system can be operated by the single remote commander 1, which fact provides for more convenience in use.

However, in such a remote commander 1, when an operation key corresponding to a memory section in which data transmitted from another remote commander is not previously stored is operated, the above-mentioned key operation is treated as a transmission error in the remotely-controlled apparatus.

The invention seeks to provide a remote commander which can remove the above-mentioned disadvantages and which can be used more conveniently.

According to the invention there is provided a remote commander in which data transmitted from another remote commander can be received, stored as user remote control data corresponding to respective operation keys, and transmitted by operating said operation keys, characterised by a read only memory for storing original remote control data and switching means for selecting and using said user remote control data or said original remote control data.

Preferably, the switched condition of the above-mentioned switching means is displayed.

Since the remote commander includes the read only memory (ROM) in which the original remote control data is stored, when equipment which can be controlled by this original remote control data is used it is not necessary to store the transmitting data in response to the operation key in advance. Since the user remote control data and the original remote control data can be selectively used, the remote commander can be applied to a wide variety of equipment.

Preferably, when the user remote control data is used, if an operation key for which data transmitted from the other remote commander is not correspondingly stored is operated, the stored original remote control data corresponding to this operation key is transmitted. Thus, it is not necessary to store in advance data for pieces of equipment which can be controlled by the original remote control data. Further, when a wrong key is operated inadvertently, this key operation is not treated as a transmission error.

The invention will now be further described, by way of illustrative and non-limiting example, with reference to the accompanying drawings, in which:

Figure 1 shows a previously proposed remote commander;

Figure 2 is a block diagram of a remote commander embodying the invention;

Figure 3 is a plan view of the remote commander embodying the invention; and

Figures 4, 5 and 6 are flow diagrams used to explain the operation of the remote commander embodying the invention.

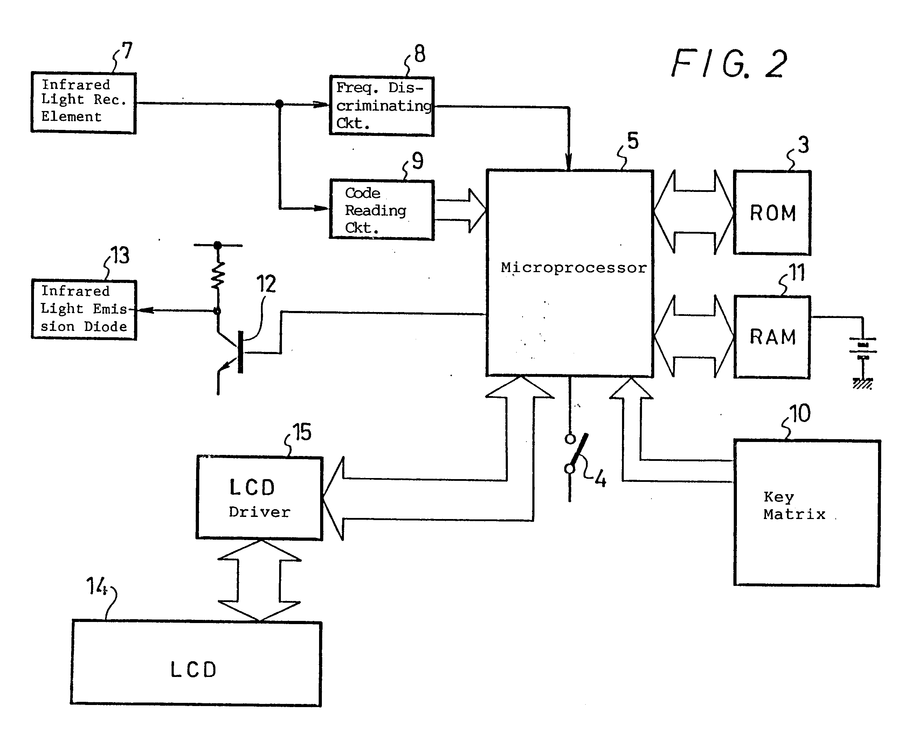

A remote commander embodying the invention will now be described with reference to Figures 2 to 6 of the drawings.

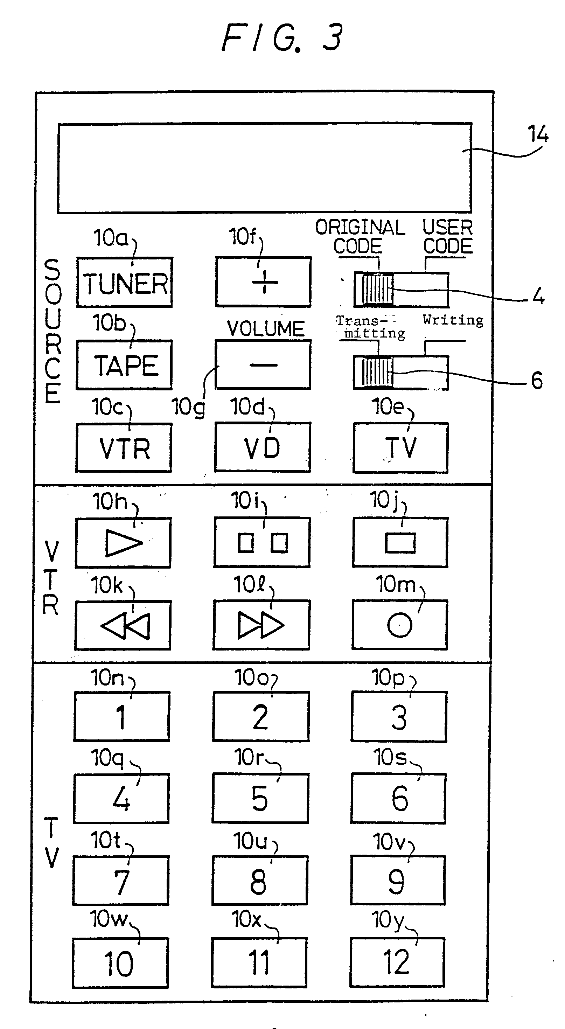

This embodiment provides a remote commander for a remotely-controlled apparatus utilising infra-red rays and which is formed to be capable of transmitting the transmitted data again by a microprocessor 5. Figure 3 is a plan view of the remote commander according to this embodiment. In Figure 3, reference numeral 6 denotes a transmission-writing change-over switch by which the remote commander can be switched to a transmission mode or a writing mode. When the switch 6 is switched to the writing position, the remote commander is configured to be the same as that shown at 1 in Figure 1. Namely, at that time, as shown in Figure 2, frequency shift keyed (FSK) data, for example, transmitted from another remote commander 2, is received by an infrared light receiving element 7. The transmitted data developed at the output of the light receiving element 7 is supplied to a frequency discriminating circuit 8, which discriminates the transmission frequency of the thus transmitted data, and also is supplied to a code reading circuit 9 which detects the peak level and reads a code of the transmitted data. Identifying data from the frequency discriminating circuit 8 and code data developed at the output of the code reading circuit 9 are supplied to the microprocessor 5 and then written in a random access memory (RAM) 11 at an address thereof corresponding to an operation key selected from operation keys 10a, 10b ... 10y forming a key matrix 10, for example an operation key 10i, as user remote control data. This writing operation is executed as necessary.

In this embodiment, in addition to the RAM 11, there is provided a read only memory (ROM) 3 in which original remote control data to be transmitted in response to operation of the operation keys 10a, 10b, ... 10y forming the key matrix 10 have already been written. The original remote control data are specified remote control data such as data transmitted from the remotely-controlled apparatus that belongs to the TV receiver, the VTR, the audio equipment and so on made by the company S when this remote commander, for example, is manufactured by the company S. Further, in this embodiment, there is provided an original code - user code change-over switch 4 which switches the remote commander to an original remote control data transmission mode or a user remote control data transmission mode. When the original remote control data or the user remote control data is transmitted, for example, FSK original remote control data or user remote control data obtained from the microprocessor 5 are supplied through a driver circuit 12 to an infra-red light emitting diode (LED) 13. The infra-red LED 13 transmits infra-red remote control signals to respective pieces of equipment. In this embodiment, a display signal from the microprocessor 5 is supplied through a liquid crystal driver circuit 15 to a liquid crystal display (LCD) panel 14 which displays the contents of various commands and which displays the switched condition of the original code - user code change-over switch 4, thus informing the operator whether the original remote control data or the user remote control data is transmitted.

In the thus-arranged remote commander, upon writing, as shown in Figure 1, another remote commander 2 is located in opposing relation to the remote commander according to this embodiment. Then, the transmitting-writing change-over switch 6 shown in Figure 3 is switched to the writing position and, thereafter, any one of the operation keys 2a, 2b ... of the other remote commander 2 for the transmitted data to be written is operated. Also, one operation key 10i of the corresponding operation keys 10a, 10b ... 10y of the remote commander of this embodiment is operated, whereby it is decided by the microprocessor 5 whether or not the code is read out on the basis of the signals from the frequency discriminating circuit 8 and the code reading circuit 9. If the code is read out, this code is written in the RAM 11 at an address thereof specified by the thus selected operation key 10i. This operation is repeatedly executed at necessary times.

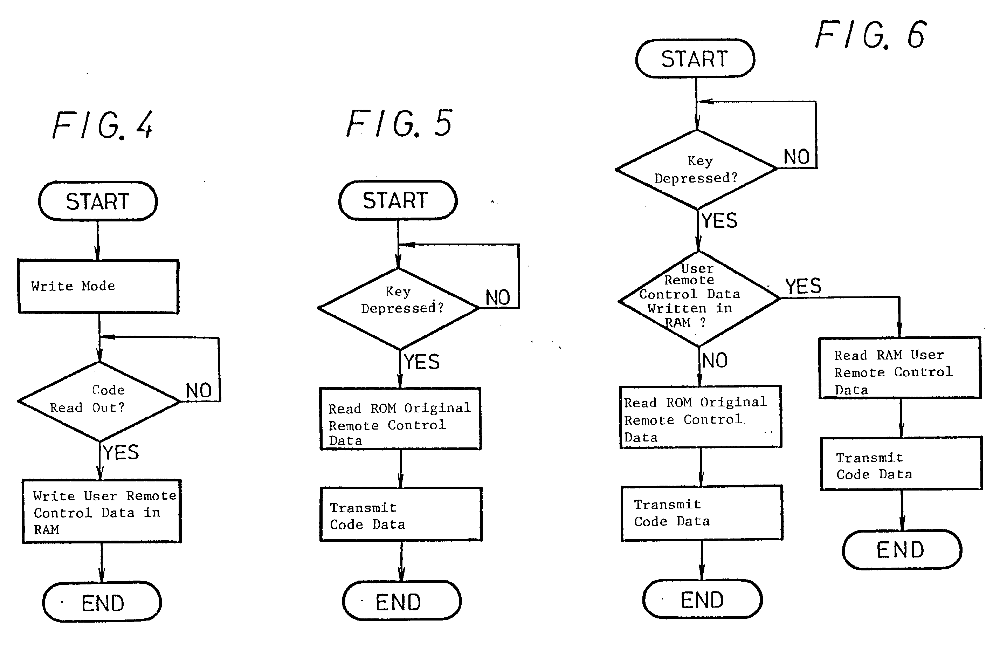

When the remote commander of this embodiment is utilised as a commander, the transmitting-writing change-over switch 6 is switched to the transmitting position. In this case, when the pieces of equipment to be remotely-controlled, for example a TV receiver, a VTR, audio equipment and so on, are all made by, for example, the company S, and can be controlled by the original remote control data, the original code - user code change-over switch 4 is connected to the original code position. At that time, as shown in Figure 5, it is decided whether the operation keys 10a, 10b ... 10y are operated or not. If they are operated, the original remote control data is read out from the ROM 3 at the address thereof corresponding to, for example, the operation key 10i that is operated. Then, this original remote control data is transmitted from the infra-red LED 13 to control the predetermined equipment.

When the original code - user code change-over switch 4 is connected to the user code position and the user remote control data previously written in the RAM 11 is transmitted again, the remote commander of this embodiment is operated as shown in Figure 6. At that time, it is decided by the microprocessor 5 whether the operation keys 10a, 10b ... 10y are operated or not. If the operation key 10i, for example, is operated, it is decided whether user remote control data is written in the RAM 11 at the address thereof corresponding to the operation key 10i. If such data is written therein, the user remote control data written in the address of the RAM 11 corresponding to the operation key 10i is transmitted to control the predetermined equipment. However, at that time, if user remote control data is not written in the address of the RAM 11 corresponding to the operation key 10i, the original remote control data is read out from the address of the ROM 3 corresponding to the operation key 10i and this original remote control data is transmitted.

Since the remote commander of this embodiment is constructed as described above, transmission data corresponding to each operation key of a remote commander for a TV receiver made by, for example, the company S, transmission data corresponding to each operation key for a remote commander for a VTR made by the company V, and transmission data corresponding to each key of a remote commander for audio equipment made by the company M can be written in response to the respective operation keys 10a, 10b ... 10y. Thus, an AV system arranged by combining pieces of equipment made by different manufacturers can conveniently be operated by a single remote commander.

In the foregoing case, when the original remote control data of the company S is written in the ROM 3, it is not necessary to write transmission data of each operation key of the remote commander that belongs to the TV receiver made by the company S. In this case, even when the original code - user code change-over switch 4 is connected to the user code position, the transmission data is not written in the RAM 11 in response to each operation key of the remote commander that belongs to the TV receiver so that, as shown in Figure 6, this original remote control data is read out from the ROM 3, thus controlling the operation of this TV receiver satisfactorily. In other words, when equipment which can be controlled by the original remote control data stored in the ROM 3 is used, the transmission data does not have to be written in advance in response to the key operation. This makes the remote commander more useful. The original remote control data and the user remote control data can be selectively used by changing over the original code - user code change-over switch 4. For example, in addition to one AV system (that is, one set of AV system components) made by, for example, the company S, a TV receiver, a VTR, an audio equipment or the like made by a company different from the company S can be remotely-controlled. Thus, it is convenient for the kinds of remotely-controllable equipment to be increased. Further, since the LCD panel 14 displays the switched condition of the original code - user code change-over switch 4, the user can recognise the switched condition at a glance. Furthermore, when the user remote control data is used, if an operation key relating to a memory section in which corresponding transmission data of another remote commander 2 is not stored is operated, the previously stored original remote control data is transmitted in response to operation of the key. Thus, even when the wrong key is operated inadvertently, a transmission error can be avoided.

According to the above-described embodiment of the invention, since transmission data corresponding to the respective operation keys of respective remote commanders made by different manufacturers can be written in response to the respective operation keys 10a, 10b ... 10y and can be transmitted again, it is convenient for pieces of equipment made by the different manufacturers to be operated by the single remote commander. Further, the remote commander embodying the invention includes the ROM 3 in which particular original remote control data is stored, so that when equipment which can be controlled by the original remote control data stored in the ROM 3 is used, the transmission data does not have to be written in advance in response to the operation key. Thus, the remote commander becomes more useful. By switching the original code - user code change-over switch 4, it is possible to select the original remote control data or the user remote control data, that is to remotely control the TV receiver, the VTR, the audio equipment or the like made by a different company in addition to one set of AV system components made by the particular company. Thus, the useful features arises that the kinds of remotely-controllable equipment are increased. Further, since the LCD display panel 14 displays the switched condition of the original code - user code change-over switch 4, the useful features arises that the user can recognise the switched condition at a glance. Furthermore, when the user remote control data is used, even if an operation key relating to a memory section in which corresponding transmission data of other remote commander 2 is not stored is operated, the previously stored original remote control data is transmitted in response to the key operation. Thus, even when a wrong operation key is operated unintentionally, a transmission error can be avoided.

## Claims

1. A remote commander in which data transmitted from another remote commander (2) can be received, stored as user remote control data corresponding to respective operation keys (10a, 10b, ...), and transmitted by operating said operation keys, characterised by a read only memory (3) for storing original remote control data and switching means (4) for selecting and using said user remote control data or said original remote control data.

2. A remote commander according to claim 1, comprising switched condition display means (14) for displaying the switched condition of the switching means (4).

3. A remote commander according to claim 1 or claim 2, which is so operative that, when said user remote control data is used, if an operation key for which said user remote control data is not stored is operated, said stored original remote control data corresponding to said operation key is transmitted.

## Patentansprüche

1. Fernsteuerung, in welcher von einer anderen Fernsteuerung (2) übertragene Daten empfangen, als mit zugeordneten Betätigungstasten (10a, 10b, ...) korrespondierende Benutzerfernsteuerungsdaten gespeichert und durch Betätigung der Betätigungstasten übertragen werden können, gekennzeichnet durch einen Nur-Lese-Speicher (3) zum Speichern ursprünglicher Fernsteuerungsdaten und eine Schalteinrichtung (4) zum Auswählen und Benutzen der Benutzerfernsteuerungsdaten oder der ursprünglichen Fernsteuerungsdaten.

2. Fernsteuerung nach Anspruch 1, mit einer Schaltzustandanzeigeeinrichtung (14) zum Anzeigen des geschalteten Zustandes der Schalteinrichtung (4).

3. Fernsteuerung nach Anspruch 1 oder 2, die derart betreibbar ist, daß bei Benutzung der Benutzerfernsteuerungsdaten, wenn eine Betätigungstaste, für welche die Benutzerfernsteuerungsdaten nicht gespeichert sind, die mit dieser Betätigungstaste korrespondierenden ursprünglichen Fernsteuerungsdaten übertragen werden.

## Revendications

1. Télécommande dans laquelle des données transmises depuis une autre télécommande (2) peuvent être reçues, stockées en tant que données de télécommande utilisateur correspondant à des touches de fonction respectives (10a, 10b, ...) et transmises par actionnement desdites touches de fonction, caractérisée par une mémoire morte (3) pour stocker des données de télécommande originales et par un moyen de commutation (4) pour sélectionner et utiliser lesdites données de télécommande utilisateur ou lesdites données de télécommande originales.

2. Télécommande selon la revendication 1, comprenant un moyen d'affichage de condition commutée (14) pour afficher la condition commutée du moyen de commutation (4).

3. Télécommande selon la revendication 1 ou 2, qui peut fonctionner de telle sorte que, lorsque lesdites données de télécommande utilisateur sont utilisées, si une touche de fonction pour laquelle lesdites données de télécommande utilisateur ne sont pas stockées est actionnée, lesdites données de télécommande originales stockées correspondant à ladite touche de fonction sont transmises.

EP 0 289 625 B1

# FIG. 1

FIG. 2

Infrared Light Rec. Element — 7

Freq. Discriminating Ckt. — 8

Code Reading Ckt. — 9

Microprocessor — 5

ROM — 3

RAM — 11

Infrared Light Emission Diode — 13

12

LCD Driver — 15

LCD — 14

Key Matrix — 10

4

EP 0 289 625 B1

# FIG. 3

SOURCE

| 10a TUNER | 10f + | ORIGINAL CODE / USER CODE — 4 |
| 10b TAPE | VOLUME — (10g) | Transmitting / Writing — 6 |
| 10c VTR | 10d VD | 10e TV |

VTR

| 10h ▷ | 10i □□ | 10j ▭ |
| 10k ◁◁ | 10ℓ ▷▷ | 10m ○ |

TV

| 10n 1 | 10o 2 | 10p 3 |
| 10q 4 | 10r 5 | 10s 6 |
| 10t 7 | 10u 8 | 10v 9 |
| 10w 10 | 10x 11 | 10y 12 |

## FIG. 4

```
      ┌──────────┐
      │  START   │
      └────┬─────┘
           ▼
  ┌─────────────────┐
  │   Write Mode    │
  └────────┬────────┘
           ▼
       ╱───────╲
      ╱  Code   ╲──── NO
      ╲ Read Out?╱
       ╲───────╱
           │ YES
           ▼
  ┌─────────────────┐
  │ Write User Remote│
  │ Control Data in │
  │ RAM             │
  └────────┬────────┘
           ▼
      ┌──────────┐
      │   END    │
      └──────────┘
```

## FIG. 5

```
      ┌──────────┐
      │  START   │
      └────┬─────┘
           ▼
       ╱───────╲
      ╱  Key    ╲──── NO
      ╲Depressed?╱
       ╲───────╱
           │ YES
           ▼
  ┌─────────────────┐
  │ Read ROM Original│
  │ Remote Control  │
  │ Data            │
  └────────┬────────┘
           ▼
  ┌─────────────────┐
  │ Transmit        │
  │ Code Data       │
  └────────┬────────┘
           ▼
      ┌──────────┐
      │   END    │
      └──────────┘
```

## FIG. 6

```
      ┌──────────┐
      │  START   │
      └────┬─────┘
           ▼
       ╱───────╲
      ╱  Key    ╲──── NO
      ╲Depressed?╱
       ╲───────╱
           │ YES
           ▼
       ╱─────────╲
      ╱   User    ╲──── YES
      ╱  Remote    ╲
      ╲ Control Data╱
      ╲ Written in ╱
       ╲  RAM ?   ╱
           │ NO
           ▼                          ▼
  ┌─────────────────┐      ┌─────────────────┐
  │ Read ROM Original│     │ Read RAM User   │
  │ Remote Control  │      │ Remote Control  │
  │ Data            │      │ Data            │
  └────────┬────────┘      └────────┬────────┘
           ▼                         ▼
  ┌─────────────────┐      ┌─────────────────┐
  │ Transmit        │      │ Transmit        │
  │ Code Data       │      │ Code Data       │
  └────────┬────────┘      └────────┬────────┘
           ▼                         ▼
      ┌──────────┐            ┌──────────┐
      │   END    │            │   END    │
      └──────────┘            └──────────┘
```

EP 0 289 625 B1